Europäisches Patentamt

European Patent Office

Office européen des brevets

(19)

(11) Veröffentlichungsnummer: **0 053 672**

**A2**

(12) # EUROPÄISCHE PATENTANMELDUNG

(21) Anmeldenummer: 81108182.7

(22) Anmeldetag: 09.10.81

(51) Int. Cl.³: **H 01 L 21/82**
H 01 L 21/32, H 01 L 27/10
//G11C11/24

(30) Priorität: 08.12.80 DE 3046218

(43) Veröffentlichungstag der Anmeldung:
16.06.82 Patentblatt 82/24

(84) Benannte Vertragsstaaten:
AT BE CH FR GB LI NL

(71) Anmelder: SIEMENS AKTIENGESELLSCHAFT Berlin
und München
Postfach 22 02 61
D-8000 München 22(DE)

(72) Erfinder: Hofmann, Rüdiger, Dr.
Ruffinistrasse 16
D-8000 München 19(DE)

(54) Verfahren zur Erzeugung einer Eintransistor-Speicherzelle in Doppelsilizium-Technik.

(57) Die Erfindung bezieht sich auf ein Verfahren zur Erzeugung einer Eintransistorspeicherzelle in Doppelsiliziumgate-Technik mit einer Bitleitung aus dotiertem Material und einer Wortleitung aus Metall. Nachteilig ist bei solchen Speicherzellen, daß bei zunehmender Integrationsdichte Laufzeiteffekte auftreten, die die Arbeitsgeschwindigkeit des Bausteins in unerwünschter Weise absenken. Zur Behebung dieses Nachteils sieht die Erfindung vor, daß nach der Varaktorgateoxydation im Bereich der späteren Bitleitung des Auswahltransistors und der Speicherkapazität eine Implantation von Elektrizitätsträgern der einen Polarität erfolgt, die im Verlauf eines späteren Prozess-Schrittes im Gatebereich durch eine Implantation mit Elektrizitätsträgern entgegengesetzter Polarität kompensiert wird. Außerdem wird beim Aufbringen der ersten Polysiliziumschicht der dotierte Bitleitungsbereich mit einem Polysiliziumstreifen kontaktiert. Das Verfahren kann insbesondere bei hochintegrierten Speicherbausteinen von z.B. 262 kBit angewendet werden.

FIG 4a

FIG 4b

FIG 4c

./...

FIG 4d

FIG 4e

FIG 4f

SIEMENS AKTIENGESELLSCHAFT ·     Unser Zeichen
Berlin und München            VPA 80 P 2091 E

Verfahren zur Erzeugung einer Ein-Transistor-Speicherzelle
in Doppelsilizium-Technik.

Die Erfindung betrifft ein Verfahren zur Erzeugung einer
Ein-Transistor-Speicherzelle in Doppelsilizium-Gate-Technik
mit einer Bitleitung aus dotiertem Material und einer Wortleitung aus Metall.

In hochintegrierten Speicherbausteinen müssen die einzelnen
Bauelemente wie Transistoren, Widerstände, Kapazitäten mit
möglichst kleinem Platzbedarf angeordnet werden. Dieses
Problem tritt besonders bei Speicherbausteinen hoher und
höchster Kapazität wie z. B. mehr als 65 000 bit auf einem
Chip bei der Auslegung der Speicherzelle auf.

Die bekannte in dynamisch arbeitenden Speicherbausteinen
verwendete Ein-Transistor-Zelle besteht aus einem Auswahltransistor, einer Speicherkapazität, einer Bit- und einer
Wortleitung sowie im günstigsten Fall aus einem halben
Kontakt pro Zelle. Verwendet man zur Herstellung dieser
Zelle eine Poly-Silizium-Gate-Technologie wie z. B. die
Doppel-Poly-Si$^2$-Gate-Technologie, so lassen sich zwei
verschiedene Zellmodifikationen unterscheiden: Nämlich
die Eintransistorzelle mit einer Bitleitung aus Metall (Al)
und der Wortleitung aus Poly-Silizium Si1 oder Si2 oder
die Eintransistorzelle mit einer Bitleitung aus dotiertem
Material (z. B. Diffusion oder Implantation) und der Wortleitung aus Metall.

Beide Ausführungsarten haben als wesentlichen Nachteil,
daß auf der jeweils hochohmigen Leitung (Fall 1: Poly-Si-
Wortleitung, Fall 2: Diffusionsbitleitung) bei zunehmender
Integrationsdichte Laufzeiteffekte auftreten, die die
Arbeitsgeschwindigkeit des Bausteins in unerwünschter Weise
Zk 1 Fdl/19. 11. 1980

Laufzeiteffekte auf der Polysiliziumwortleitung lassen sich über den Weg einer Silizid-Technologie wie aus der DBP 2 815 605 bekannt, beheben.

Aufgabe der vorliegenden Erfindung ist es, ein Verfahren anzugeben, bei dem bei Eintransistorspeicherzellen in Doppelsiliziumtechnik, bei denen die Wortleitung aus Metall und die Bitleitung aus dotiertem Material besteht, Laufzeiteffekte auf der diffundierten oder implantierten Bitleitung vermieden werden.

Zur Lösung dieser Aufgabe wird gemäß der Erfindung derart verfahren, daß nach der Varaktorgateoxydation im Bereich der späteren Bitleitung, des Auswahltransistors und der Speicherkapazität eine Implantation von Elektrizitätsträgern der einen Polarität erfolgt, die im Verlauf eines späteren Prozess-Schrittes im Gatebereich durch eine Implantation mit Elektrizitätsträgern entgegengesetzter Polarität wie bei der ersten Implantation vervollständigt wird, und daß beim Aufbringen der ersten (Poly-Si-1) Schicht der dotierte Bitleitungsbereich mit einem Polysiliziumstreifen kontaktiert wird.

Eine weitere Ausgestaltung des Verfahrens sieht vor, daß nach der Varaktorgateoxydation eine Implantation von Elektrizitätsträgern der einen Polarität im Gebiet der späteren Bitleitung, des Auswahltransistors und der Speicherkapazität erfolgt, daß anschließend mit einer definierten Dünnoxydätzung das Gebiet der späteren Bitleitung freigegeben wird, daß dann die Varaktorpolysiliziumschicht (Poly-Si-1) abgeschieden und so strukturiert wird, daß auch über der vorgesehenen Bitleitungsfläche ein Polysiliziumstreifen verbleibt, der über den Oxydschlitz Kontakt mit der implantierten Schicht hat, daß anschließend im Bereich des Auswahltransistors das Varaktorgateoxyd abgeätzt und ein zweiter Gateoxyd aufgewachsen wird, daß danach eine weitere Implantation mit gegenüber der ersten entgegengesetzt geladenen Elektrizitätsträgern erfolgt, daß anschließend die zweite Polysiliziumschicht (Poly-Si-2) aufgebracht und strukturiert wird und der restliche Prozess wie an sich bekannt verläuft.

Durch die Parallelschaltung des dotierten Bereiches mit einem Polysiliziumstreifen im Bereich der Bitleitung wird diese um den Faktor 10 niederohmiger als eine nur dotierte Bitleitung. Durch die Selbstjustierung des Auswahltransistors erhält man minimal wählbare und von Justiertoleranzen unabhängige Kanallängen. Durch Wahl des Massepotentials $V_{SS}$ als Deckelektrode erhält man wobbelunempfindliche Speichervaraktoren. Durch Verwendung einer konventionellen Depletiontechnik sind die Prozess-Schwierigkeiten gering.

Eine Verringerung des Widerstandes der Polysiliziumschichten kann zusätzlich durch Silizidbildung auf der Oberfläche der Schichten erreicht werden.

Anstatt einer zweiten Implantation kann in Abweichung des Verfahrens die im Transfergatebereich vorhandene, durch die erste Implantation erzeugte Schicht auch durch Abätzen nach dem Abätzen des Varaktorgateoxyds unwirksam gemacht werden.

Anhand der Figuren 1 bis 4 wird die Erfindung näher erläutert.
Es zeigen:
Fig. 1 einen Stromlauf einer Eintransistorspeicherzelle wie an sich bekannt,
Fig. 2 einen Querschnitt durch eine bekannte Eintransistorspeicherzelle mit Aluminiumbitleitung und Polysiliziumwortleitung,
Fig. 3 einen Querschnitt durch eine bekannte Eintransistorspeicherzelle mit dotierter Bitleitung und Aluminiumwortleitung,

Fig. 4 Querschnitte durch eine Eintransistorspeicherzelle nach der Erfindung nach den wesentlichen Verfahrensschritten.

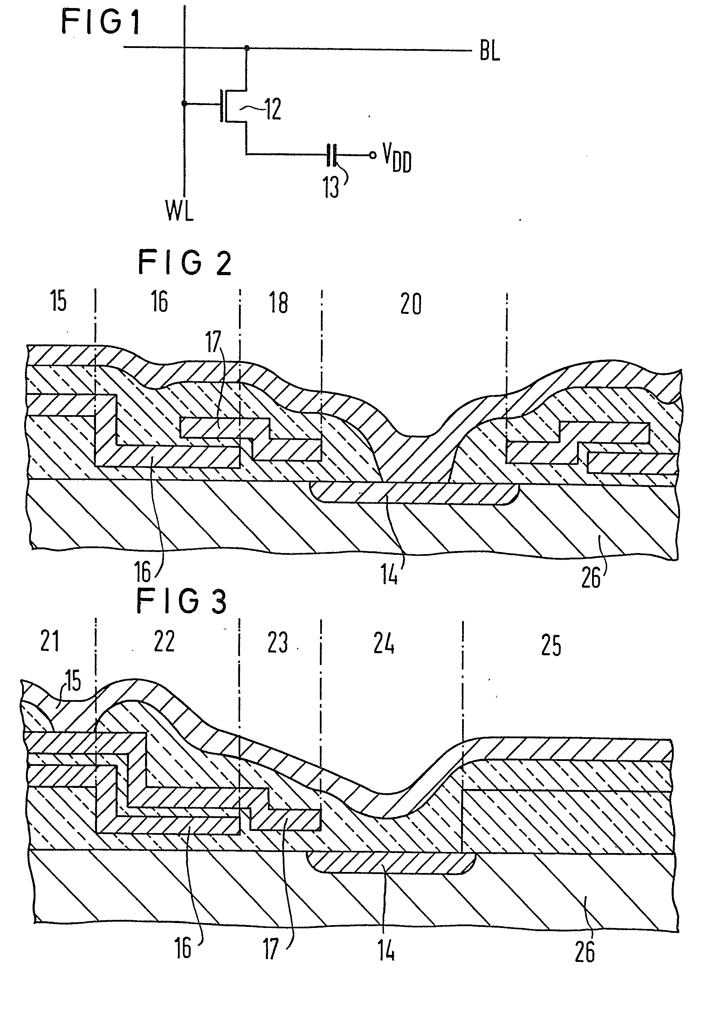

In Fig. 1 ist eine bekannte Eintransistorspeicherzelle dargestellt. Der Auswahltransistor 12 ist mit seiner Drain- Elektrode mit der Bitleitung BL und mit seiner Gateelektrode mit der Wortleitung WL verbunden. Die Source-Elektrode ist über den Speicherkondensator 13 an das Potential VDD geführt.

In Fig. 2 ist der Querschnitt einer in Doppelsiliziumgatetechnik hergestellten Eintransistorspeicherzelle gezeigt, die eine Aluminiumbitleitung und eine Polysiliziumwortleitung aufweist. Die dortierte Schicht 14, die entweder durch Diffusion oder Implantation erzeugt wird, ist mit der Aluminiumleitung 15 verbunden. Die erste Polysiliziumschicht 16 bildet durch Anlegen einer Spannung den Varaktor, während die zweite Polysiliziumschicht 17 die Transferelektrode darstellt. Der Bereich 16 zeigt dabei den Varaktorbereich und der Bereich 18 den Transistorbereich. Diesem schließt sich der Bitleitungskontaktbereich 20 an. Dieser Kontaktbereich ist jeweils für zwei Speicherzellen gemeinsam.

Eine weitere in Doppelsiliziumgatechnik aufgebaute Eintransistorspeicherzelle im Querschnitt zeigt die Fig. 3, wobei die Bitleitung aus einem dotierten Bereich 14 und die Wortleitung aus Aluminium 15 besteht. Die erste Polysilizium schicht 16 ist unterhalb der zweiten Polysiliziumschicht 17 angebracht, wobei die zweite Polysiliziumschicht 17 zugleich die Transferelektrode darstellt. Von links nach rechts sind folgende Bereiche zu erkennen: Der Bereich des Wortleitungskontaktes 21, der Varaktorbereich 22, der Transistorbereich 23, der Bitleitungsbereich 24 und der Feldbereich 25. Der Dotierungsbereich 14 ist in das Substrat, wie an sich bekannt, eingebettet.

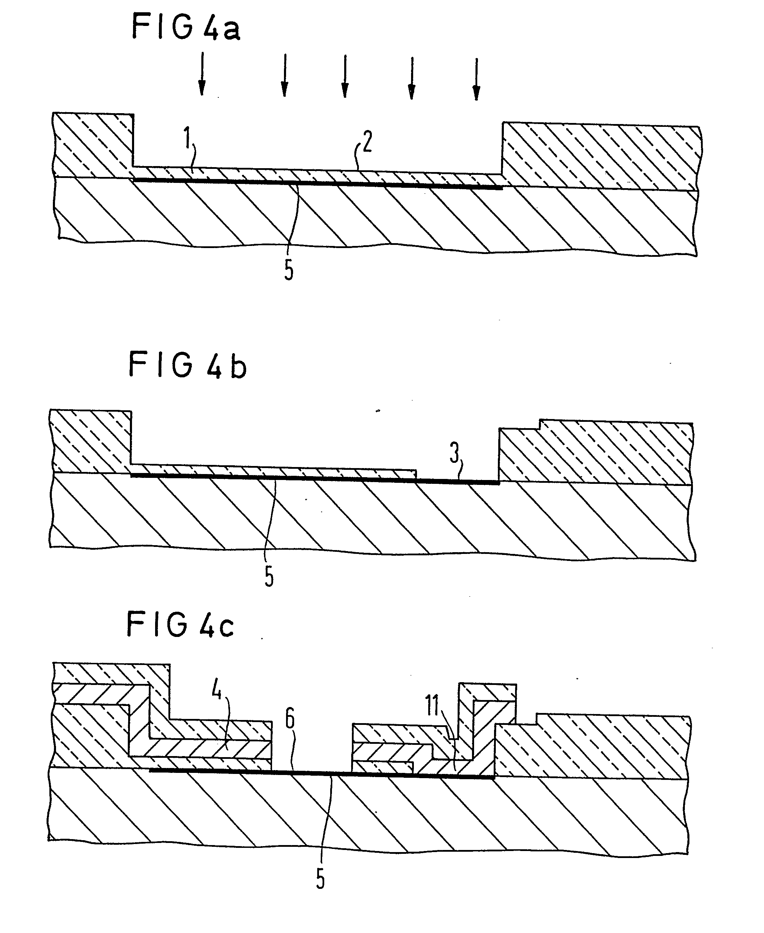

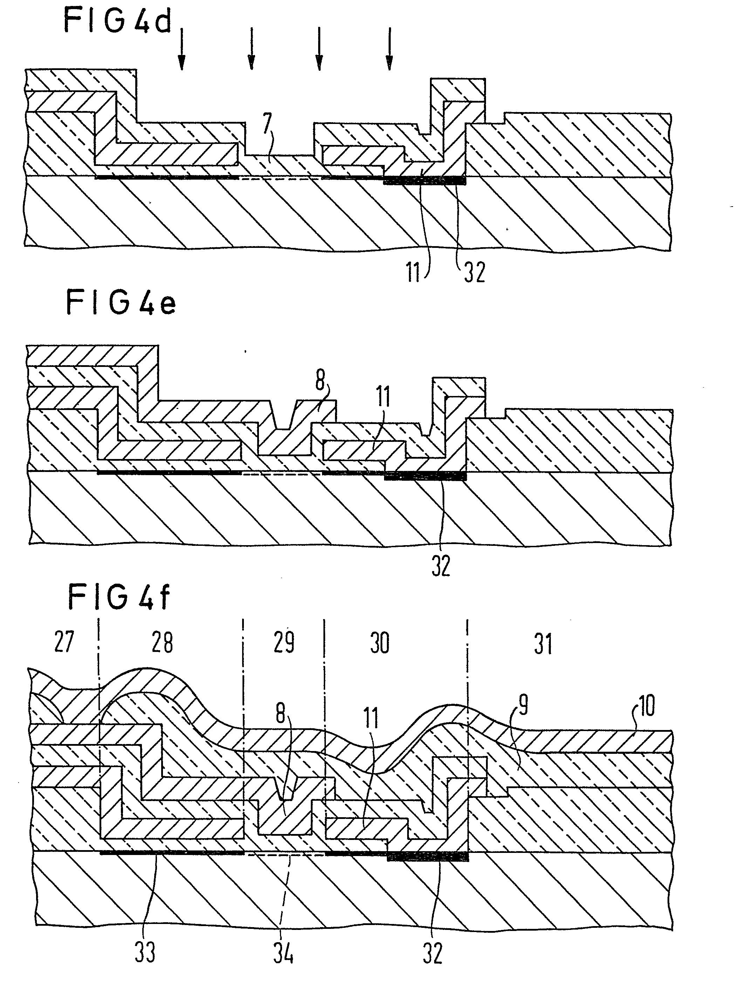

Das Verfahren nach der Erfindung wird anhand der Fig. 4 näher erläutert.

Nach der Oxidation des Varakter-Gateoxids 1 wird mit der sogenannten Depletion-Maske das Gebiet 2 der Bitleitung, des Auswahltransistors und der Speicherkapazität implantiert ($n^+$-Implantation durch das Gateoxid hindurch ) ( Fig. 4 a). Anschließend wird mit einer definierten Dünnoxidätzung (sog. a/b Kontaktlochätzung) das Gebiet der späteren Bitleitung freigelegt (Fig. 4b). Bei der Ätzung des anschließen abgeschiedenen Varaktor-Poly-Siliziums 4 (Poly-Si-1) wird auch über der Bitleitungsfläche ein Poly-Si-1 Streifen 11 belassen, der über den Oxidschlitz 3 Kontakt mit der implantierten Schicht 5 hat (Fig. 4 c). Anschließend wird im geöffneten Bereich 6 des Auswahltransistors das erste Gateoxid/(mit den Poly-Si-Kanten als Maske) angeätzt, ein zweites Gateoxid 7 aufgewachsen und dann eine Enhancement-Implantation durchgeführt (Fig. 4d ). Nach der folgenden Abscheidung und Ätzung der zweiten Polysiliziumschicht 8 (Poly-Si-2) ist die Speicherzelle strukturiert.(Fig 4e ). Der weitere Prozeßverlauf erfolgt in bekannter Weise. Fig. 4f zeigt die fertige Eintransistorzelle im Querschnitt. Dabei sind von links nach rechts wieder folgende Bereiche zu erkennen. Der Wortleitungskontaktbereich 27, der Depletion-Varaktorbereich 28, der selbstjustierende Transistorbereich 29, der niederohmige Bitleitungsbereich 30 und der Feldbereich 31. Zwischen die Poly-Silizium-2 Schicht 8 und der Aluminiumleitung 10 ist ein Zwischenoxyd 9 zur Isolation aufgebracht. Der als Bitleitung dienende Dotierungsbereich 32 ist unmittelbar mit einer Polisiliziumschicht 11 kontaktiert, die Depletion-Implantation ist im Transfergatebereich 8 durch eine Enhancement-Implantation neutralisiert. Die Reihenfolge der Implantation in bezug auf deren Polarität ist dabei davon abhängig, ob ein n-Kanal oder ein p-Kanal-Transistor erhalten werden soll.

4 Figuren
4 Patentansprüche

Patentansprüche

1. Verfahren zur Erzeugung einer Eintransistor-Speicherzelle in Doppelsiliziumgate-Technik mit einer Bitleitung
aus dotiertem Material und einer Wortleitung aus Metall,
d a d u r c h   g e k e n n z e i c h n e t, daß nach
der Varaktorgateoxydation im Bereich der späteren Bitleitung des Auswahltransistors und der Speicherkapazität
eine Implantation von Elektrizitätsträgern der einen Polarität erfolgt, die im Verlauf eines späteren Prozess-
Schrittes im Gatebereich durch eine Implantation mit Elektrizitätsträgern entgegengesetzter Polarität wie bei der ersten
Implantation vervollständigt wird und daß beim Aufbringen
der ersten Polysiliziumschicht (Poly-Si-1) der dotierte
Bitleitungsbereich mit einem Polysiliziumstreifen kontaktiert
wird.

2. Verfahren nach Anspruch 1, d a d u r c h   g e k e n n -
z e i c h n e t, daß nach der Varaktorgateoxydation eine
Implantation von Elektrizitätsträgern der einen Polarität
im Gebiet der späteren Bitleitung des Auswahltransistors
und der Speicherkapazität erfolgt, daß anschließend mit
einer definierten Dünnoxydätzung das Gebiet (3) der späteren Bitleitung freigelegt wird, daß dann die Varaktorpolysiliziumschicht (4) (Poly-Si-4) abgeschieden und so strukturiert wird, daß auch über der vorgesehenen Bitleitungsfläche ein Polysiliziumstreifen (11) verbleibt, der über
den Oxydschlitz (3) Kontakt mit der implantierten Schicht
(5) hat, daß anschließend im Bereich des Auswahltransistors
das Varaktorgateoxyd (1) abgeätzt und ein zweites Gateoxyd
(7) aufgewachsen wird, daß danach eine weitere Implantation
mit gegenüber der ersten entgegengesetzt geladenen Elektrizitätsträgern erfolgt, daß anschließend die zweite Polysiliziumschicht (8) (Poly-Si-2) aufgebracht und strukturiert
wird und der restliche Prozess wie an sich bekannt verläuft.

3. Verfahren nach einem der vorhergehenden Ansprüche, d a -
d u r c h   g e k e n n z e i c h n e t, daß auf den
Polysiliziumschichten Silizid abgeschieden wird.

4. Verfahren nach einem der vorhergehenden Ansprüche, d a d u r c h   g e k e n n z e i c h n e t, daß an Stelle der zweiten Implantation die im Gatebereich durch die erste Implantation vorhandene Schicht durch Abätzen nach dem Abätzen des Varaktorgateoxyds unwirksam gemacht wird.

**FIG 1**

BL

12

$V_{DD}$

13

WL

**FIG 2**

15  16  17  18  20

16  14  26

**FIG 3**

21  22  23  24  25

15

16  17  14  26

FIG 4a

FIG 4b

FIG 4c

0053672

3/3

FIG 4d

7

11  32

FIG 4e

8

11

32

FIG 4f

27  28  29  30  31

8

11

9

10

33  34  32